# EUROPÄISCHE PATENTSCHRIFT

(11) **EP 0 517 745 B1**
(45) Veröffentlichungstag und Bekanntmachung des Hinweises auf die Patenterteilung: **10.08.1994**
(21) Anmeldenummer: 91904422.2
(22) Anmeldetag: 22.02.1991
(51) Int. Cl.: H03K 17/97

(54) **ELEKTRONISCHER SCHALTER**
ELECTRONIC SWITCH
COMMUTATEUR ELECTRONIQUE

(30) Priorität: 02.03.1990 DE 4006596
(43) Veröffentlichungstag der Anmeldung: 16.12.1992
(73) Patentinhaber: SIEMENS AKTIENGESELLSCHAFT, 80333 München (DE)
(72) Erfinder: LACHMANN, Ulrich, D-8000 München 70 (DE)
(86) Internationale Anmeldenummer: DE9100148
(87) Internationale Veröffentlichungsnummer: WO9113494

(56) Entgegenhaltungen:
- EP-A- 0 043 350
- US-A- 4 021 728
- US-A- 4 054 860
- Electronique Industrielle, No. 4, 15 October 1980, (Paris, FR), Y Soussi: "Des capteurs industriels économiques et simples d'emploi: les capteurs à effet Hall", pages 85-88 see page 85, left-hand column, last paragraph middle paragraph, line 14 fig. 2

## Beschreibung

Die Erfindung betrifft einen elektronischen Schalter.

Bei vielen Anwendungsfällen, insbesondere in der Automobiltechnik sowie in der Maschinen- und Anlagetechnik, ist es notwendig, die Position eines Schalthebels oder eines beweglichen Maschinenteils, das mehrere verschiedene Stellungen oder Positionen haben kann, zu erkennen und digital auszugeben. Bisher wurde das Problem hauptsächlich mit entsprechend angeordneten mechanischen Schaltern gelöst, die entweder die Last direkt schalteten, oder deren Signale von zusätzlichen Codiereinrichtungen zusammengefaßt wurden, um die Anzahl der elektrischen Leitungen zu reduzieren.

Die bekannte Lösung weist jedoch folgende Nachteile auf: Mechanische Schalter sind mit einem erheblichen Aufwand verbunden, sind störanfällig, sind schwer zu justieren und weisen relativ große Abmessungen auf. Außerdem ist ein hoher Verdrahtungsaufwand selbst bei Verwendung von Codier- und Multiplexeinrichtungen erforderlich.

Aus "Electronique Industrielle", Nr. 4, 15.10.1980, Seite 85-88 und aus US-A-4 054 860 sind weiterhin Anordnungen mit Einzelmagneten bekannt, die gegenüber Hallsensoren angeordnet sind und bei verschiedenen Positionen unterschiedliche Polarisierungsmuster in den Hallsensoren hervorrufen. Jeder Hallsensor ist dabei einem Bit eines Datenworts zugeordnet. Eine matrixförmige Anordnung von Einzelmagneten auf einem Träger ist aus der US-A-4 021 728 bekannt. Diese Anordnungen weisen je 2 Zustände je Hallsensor auf.

Nachteil dieser Anordnungen ist jedoch, die hohe Anzahl von Hallsensoren zur Umsetzung der Information in ein Datenwort.

Aufgabe der Erfindung ist es daher, einen Schalter anzugeben, der diese Nachteile nicht aufweist.

Diese Aufgabe wird durch einen Schalter gemäß Patentanspruch 1 l gelöst. Ausgestaltungen und Weiterbildungen des Erfindungsgedankens sind in Unteransprüchen gekennzeichnet.

Die Erfindung wird nachfolgend anhand der in den FIG der Zeichnung dargestellten Ausführungsbeispiele näher erläutert, wobei gleiche Elemente mit gleichen Bezugszeichen versehen sind. Es zeigt:
- FIG 1: eine erste Ausführungsform eines erfindungsgemäßen Schalters mit einer drehbaren Anordnung von Einzelmagneten,
- FIG 2: eine zweite Ausführungsform eines erfindungsgemäßen Schalters mit einer in Längsrichtung beweglichen Anordnung von Einzelmagneten,
- FIG 3: eine dritte Ausführungsform eines erfindungsgemäßen Schalters mit einer in Längsrichtung beweglichen Anordnung von Einzelmagneten und
- FIG 4: eine vierte Ausführungsform eines erfindungsgemäßen Schalters mit matrixförmig angeordneten Einzelmagneten.

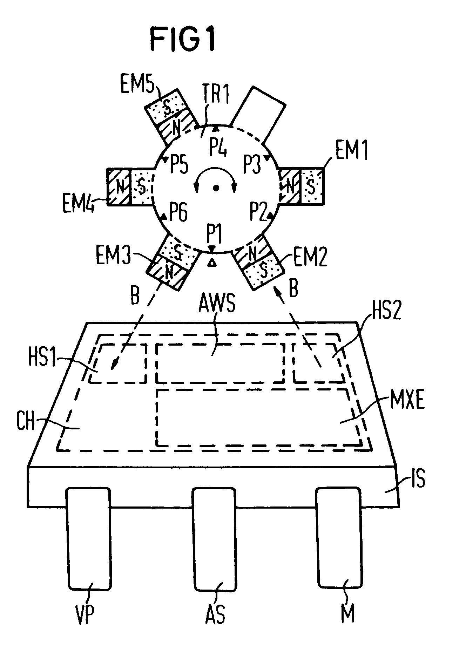

Nach FIG 1 der Zeichnung weist ein erfindungsgemäßer elektronischer Schalter einen integrierten Schaltkreis IS auf, der zwei Hallsensoren HS1 und HS2 und eine Auswerteschaltung AWS enthält. Darüber hinaus weist der integrierte Schaltkreis IS in Weiterbildung der Erfindung eine Multiplexeinrichtung MXE auf, die ebenso wie die beiden Hallsensoren HS1 und HS2 sowie die Auswerteschaltung AWS in einen Chip CH beispielsweise monolithisch integriert sind. Zudem ist bei dem erfindungsgemäßen elektronischen Schalter eine gegenüber dem integrierten Schaltkreis IS unterschiedlich positionierbare Anordnung von zueinander unbeweglichen Einzelmagneten EM1...EM5 vorgesehen, die ein der jeweiligen Position zugeordnetes Polarisierungsmuster bei den Hallsensoren HS1 und HS2 hervorruft. Die fünf Einzelmagnete EM1...EM5 sind an den Stirnseiten eines runden und um eine Achse drehbaren Trägers TR1 befestigt. Durch eine zusätzliche, in der Zeichnung nicht näher dargestellte Mechanik wird sichergestellt, daß der Träger TR1 bei sechs verschiedenen Positionen P1...P6 einrastet. Bei diesen Positionen P1...P6 ist dabei jeweils ein Magnet mit einer bestimmten Polarisierung einem Hallsensor HS1, HS2 am nächsten. Das bedeutet, daß beispielsweise bei der Position P1 im wesentlichen der Einzelmagnet EM3 mit einem von ihm weg gerichteten, eine Stärke B aufweisenden Magnetfeld auf den Hallsensor HS1 einwirkt, während gleichzeitig im wesentlichen der Einzelmagnet EM2 mit einem auf ihn gerichteten, in etwa auch die Stärke B aufweisenden Magnetfeld auf den Hallsensor HS2 einwirkt. Darüber hinaus sind aber auch Positionen, beispielsweise die Positionen P3 und P4, vorgesehen, bei denen auf einen der beiden Sensoren im wesentlichen kein Magnetfeld bzw. ein Magnetfeld von geringerer Stärke einwirkt. Jeder der Positionen P1... P6 ist nun ein ganz bestimmtes Polarisierungsmuster zugeordnet, das sich aus der Richtung des einwirkenden Magnetfeldes ergibt bzw. aus der Tatsache, daß ein Magnetfeld einwirkt oder nicht. Daraus folgt wiederum, daß insgesamt neun verschiedene Polarisierungsmuster bei Zugrundelegen von zwei Hallsensoren möglich sind. Es sind jedoch auch Ausgestaltungen mit mehr als zwei Hallsensoren möglich, bei denen die Zahl der Positionen dann entsprechend erhöht werden kann.

Das auf den jeweiligen Hallsensor einwirkende Magnetfeld erzeugt in diesem einen Strom mit einer bestimmten Stärke und einer bestimmten Stromrichtung. Die Auswerteschaltung AWS ermittelt daraus für beide Hallsensoren HS1 und HS2 jeweils die zugehörigen logischen Zustände, wobei drei Zustände möglich sind, nämlich 1,0 und -1. Diese logischen Zustände werden als Ausgangssignale der Auswerteschaltung AWS der Multiplexeinrichtung MXE zugeführt, die daraus ein seriell übertragbares Signal bildet. Aufgrund der seriellen Signalausgabe benötigt der integrierte Schaltkreis IS nur drei Anschlüsse, nämlich einen Anschluß für ein Versorgungspotential VP, einen Anschluß für ein Bezugspotential M und einen Anschluß für das serielle Ausgangssignal AS.

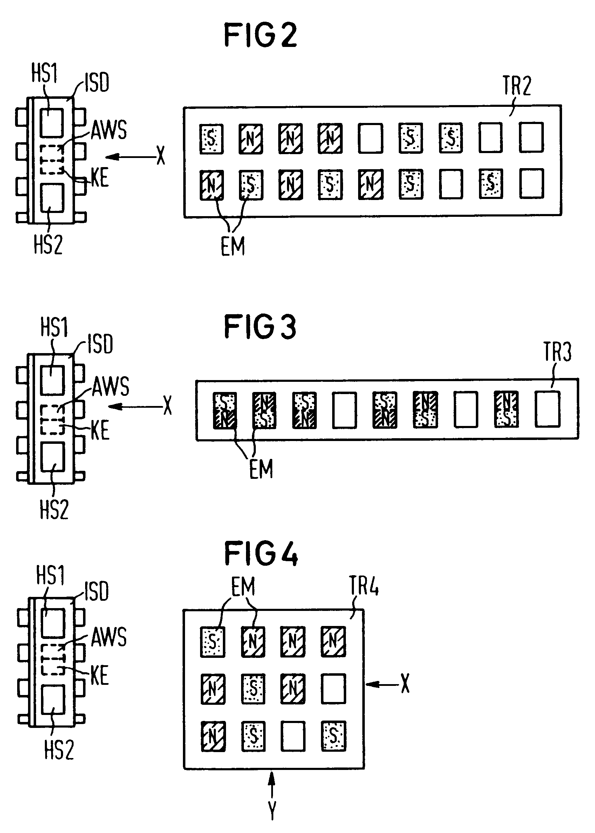

FIG 2 zeigt ein Ausführungsbeispiel, bei dem die Einzelmagnete in eine Trägerfläche TR2 eingebracht sind. Die Einzelmagnete EM sind dabei paarweise in Reihe angeordnet. Die Einzelmagnete EM eines Paares weisen dabei in etwa den gleichen Abstand wie die beiden Hallsensoren HS1 und HS2 der integrierten Schaltung IS auf und bilden ein für dieses Paar charakteristisches Polarisierungsmuster. Bei dem Polarisierungsmuster können wiederum drei Zustände unterschieden werden, nämlich eine Polarisierungsrichtung, eine entgegengesetzte Polarisierungsrichtung und keine Polarisierung. Das vorliegende Ausführungsbeispiel zeigt dabei neun Paare entsprechend den neun möglichen Kombinationen, welche neun verschiedenen Positionen entsprechen, die ebenfalls beispielsweise durch eine Einrastmechanik positioniert werden können. Bei jeder Rastposition befinden sich also über den beiden Hallsensoren HS1 und HS2 jeweils einer der Einzelmagneten EM eines Paares. Daraus ergibt sich eine eindimensionale Bewegungsrichtung, die im folgenden mit X-Richtung bezeichnet wird.

Eine weitere Ausführungsform einer ebenen Anordnung von Einzelmagneten mit eindimensionaler Bewegungsrichtung zeigt FIG 3. Im Unterschied zu dem Ausführungsbeispiel nach FIG 2 sind hierbei die Magnete nicht senkrecht zur Trägerfläche befestigt, sondern waagrecht auf einer Trägerfläche TR3. Damit schränkt sich die Anzahl der verschiedenen Polarisierungsmuster auf drei ein. Jedoch können auch hier beispielsweise neun Positionen gegeben sein, indem einige Positionen mit dem gleichen Polarisierungsmuster belegt werden. Im übrigen sind die Anordnungen nach FIG 2 und FIG 3 gleich, d.h. es findet in beiden Fällen eine integrierte Schaltung ISD Verwendung, die neben den beiden Hallsensoren HS1 und HS2 die Auswerteschaltung AWS sowie eine Codiereinrichtung KE aufweist. Die Codiereinrichtung KE setzt beispielsweise die von den Hallsensoren HS1,HS2 aufgenommenen und in elektrische Signale umgesetzten Polarisierungsmuster nach einer Signalaufbereitung durch die Auswerteschaltung AWS in einen dem Polarisierungsmuster entsprechenden Binärcode um.

In dem Ausführungsbeispiel gemäß FIG 4 sind die Einzelmagnete EM matrixförmig in einem Träger TR4 angeordnet. Dabei weisen die Zeilen jeweils vier Einzelmagnete und die Spalten jeweils drei Einzelmagnete auf. Der Abstand zwischen zwei Zeilen entspricht ungefähr dem Abstand der beiden Hallsensoren HS1,HS2 der integrierten Schaltung ISD. Bei jeder der in diesem Fall acht möglichen Positionen befindet sich über jedem der beiden Hallsensoren HS1,HS2 ein Einzelmagnet EM. Durch die matrixförmige Anordnung wird nun eine zweidimensionale Bewegung des Trägers, also ein Bewegung in X- und Y-Richtung, ermöglicht.

Allgemein werden die Stärke der Einzelmagneten, der Abstand der Hallsensoren sowie verschiedene interne Ansprechschwellen der Auswerteschaltung so ausgelegt, daß eine deutliche Unterscheidung zwischen den drei möglichen Zuständen der Polarisierung in einer Richtung, der Polarisierung in der anderen Richtung und keiner Polarisierung, erfolgen kann. Darüber hinaus sei darauf hingewiesen, daß neben den in den Ausführungsbeispielen gezeigten Ausführungsformen weitere Ausgestaltungen, insbesondere des Trägers und der verwendeten Polarisierungsmuster, möglich sind. Daneben ist auch der Aufbau der integrierten Schaltung nicht auf die Funktionsteile der Hallsensoren, der Auswerteschaltung, der Codiereinrichtung und/oder der Multiplexeinrichtung beschränkt, sondern es ist ebenso denkbar, weitere Funktionseinheiten in die integrierte Schaltung mitzuintegrieren.

Die Vorteile eines erfindungsgemäßen elektronischen Schalters sind neben der geringen Störanfälligkeit, der kleinen Abmessungen, dem niedrigen Verdrahtungsaufwand auch die Unempfindlichkeit gegenüber Staub und Feuchtigkeit, eine hohe Isolation und die kontaktlose und daher auch nur geringste Schaltkräfte erfordernde Bauweise.

## Patentansprüche

1. Elektronischer Schalter mit einem integrierten Schaltkreis (IS, ISD), der mindestens zwei Hallsensoren (HS1, HS2) und mindestens eine Auswerteschaltung (AWS) enthält, und mit einer gegenüber dem integrierten Schaltkreis (IS, ISD) unterschiedlich positionierbaren Anordnung von zueinander unbeweglichen Einzelmagneten (EM, EM1...EM5), die ein der jeweiligen Position zugeordnetes Polarisierungsmuster bei den Hallsensoren (HS1, HS2) hervorruft, wobei die Auswerteschaltung die Ausgangssignale der Hallsensoren auswertet, und wobei jeder Hallsensor ein Ausgangssignal erzeugt, das drei verschiedene Zustände annehmen kann.

2. Elektronischer Schalter nach Anspruch 1,
**dadurch gekennzeichnet,**
daß der integrierte Schaltkreis (IS, ISD) eine Codiereinrichtung (KE) aufweist, die das von der Auswerteschaltung erzeugte Ausgangssignal in einen digitalen Wert umsetzt.

3. Elektronischer Schalter nach Anspruch 1 oder 2,
**dadurch gekennzeichnet,**
daß der integrierte Schaltkreis (IS, ISD) eine Multiplexeinrichtung (MXE) aufweist, die das von der Auswerteschaltung (KE) erzeugte Ausgangssignal in ein serielles Datensignal wandelt.

4. Elektronischer Schalter nach einem der Ansprüche 1 bis 3,
**dadurch gekennzeichnet,**
daß die Einzelmagnete (EM) matrixförmig auf einem Träger (TR4) angeordnet sind.

## Claims

1. Electronic switch having an integrated circuit (IS, ISD) which contains at least two Hall sensors (HS1, HS2) and at least one evaluation circuit (AWS), and having an arrangement, which can be positioned differently with respect to the integrated circuit (IS, ISD), of individual magnets (EM, EM1 ... EM5) which can be moved with respect to one another, the said arrangement bringing about a polarization pattern, assigned to the respective position, in the said Hall sensors (HS1, HS2), the evaluation circuit evaluating the output signals of the Hall sensors and each Hall sensor producing an output signal which can assume three different states.

2. Electronic switch according to Claim 1, characterized in that the integrated circuit (IS, ISD) has a coding device (KE) which converts the output signal generated by the evaluation circuit into a digital value.

3. Electronic switch according to Claim 1 or 2, characterized in that the integrated circuit (IS, ISD) has a multiplex device (MXE) which converts the output signal generated by the evaluation circuit (AWS) into a serial data signal.

4. Electronic switch according to one of Claims 1 to 3, characterized in that the individual magnets (EM) are arranged in a matrix shape on a carrier (TR4).

## Revendications

1. Commutateur électronique comportant un circuit intégré (IS, ISD) qui comporte au moins deux capteurs de Hall (HS1, HS2) et au moins un circuit d'évaluation (AWS), et un ensemble d'aimants individuels (EM, EM1...EM5) immobiles les uns par rapport aux autres, qui peut être positionné différemment par rapport au circuit intégré (IS, SD) et fait apparaître un modèle de polarisation, associé à la position respective, dans les capteurs de Hall (HS1, HS2), le circuit d'évaluation évaluant les signaux de sortie des capteurs de Hall, et chaque capteur de Hall produisant un signal de sortie qui peut prendre trois états différents.

2. Commutateur électronique suivant la revendication 1, caractérisé par le fait que le circuit intégré (IS, ISD) possède un dispositif de codage (KE), qui convertit le signal de sortie produit par le circuit d'évaluation, en une valeur numérique.

3. Commutateur électronique suivant la revendication 1 ou 2, caractérisé par le fait que le circuit intégré (IS, ISD) possède un dispositif de multiplexage (MXE), qui convertit le signal de sortie produit par le circuit d'évaluation (KE) en un signal de données en série.

4. Commutateur électronique suivant l'une des revendications 1 à 3, caractérisé par le fait que les aimants individuels (EM) sont disposés sous la forme d'une matrice sur un support (TR4).
